(19) Europäisches Patentamt
European Patent Office
Office européen des brevets

(11) Publication number: **0 180 466**
**B1**

(12) **EUROPEAN PATENT SPECIFICATION**

(45) Date of publication of patent specification: **26.04.89**

(51) Int. Cl.⁴: **C 09 D 11/10,** H 05 K 3/02, G 03 C 1/68

(21) Application number: **85307865.7**

(22) Date of filing: **30.10.85**

(54) **Photopolymerizable composition for use as an etching-resist ink.**

(30) Priority: **30.10.84 JP 226928/84**

(43) Date of publication of application:
**07.05.86 Bulletin 86/19**

(45) Publication of the grant of the patent:
**26.04.89 Bulletin 89/17**

(84) Designated Contracting States:
**DE GB SE**

(56) References cited:
**DE-A-2 615 055**
**DE-A-2 728 780**
**FR-A-2 377 052**

**PATENTS ABSTRACTS OF JAPAN, vol. 8, no. 51 (P-259)1488r, 8th March 1984; & JP-A-58 202 440 (MITSUI TOATSU KAGAKU K.K.) 25-11-1983**

(73) Proprietor: **NIPPON KAYAKU KABUSHIKI KAISHA**
**Tokyo Fujimi Bldg. 11-2 Fujimi 1-chome**
**Chiyoda-ku**
**Tokyo 102 (JP)**

(72) Inventor: **Nawata, Kazuyoshi**
**173-4 Oaza Higashi-Takatomari**
**Onoda-shi Yamaguchi-ken (JP)**
Inventor: **Katayama, Masahito**
**3512-149 Oaza Kori Sanyo-cho**
**Asa-gun Yamaguchi-ken (JP)**
Inventor: **Yokoshima, Minoru**
**2959 Oaza Kori Sanyo-cho**
**Asa-gun Yamaguchi-ken (JP)**

(74) Representative: **Woods, Geoffrey Corlett et al**
**J.A. KEMP & CO. 14 South Square Gray's Inn**
**London WC1R 5EU (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

EP 0 180 466 B1

Courier Press, Leamington Spa, England.

**Description**

The present invention relates to a photopolymerizable composition which is curable by irradiation of ultraviolet rays and, in more detail, relates to a novel photopolymerizable composition particularly suitable as an etching-resist ink for the production of a printed-circuit board.

As an etching-resist ink or an ultraviolet curing type, a composition containing polyester, a hydroxyalkyl acrylate, a photopolymerizable monomer, a carboxylic acid having 2 to 36 carbon atoms and a photopolymerization-initiator (refer to Japanese Patent Application Laid-Open No. 51-2503 (1976)) and a composition containing polyester, a half ester of a hydroxyalkyl acrylate and a polybasic acid, a vinyl monomer having an ethylenic unsaturated bond and a photopolymerization-initiator (refer to Japanese Patent Application Laid-Open No. 57-13444 (1982)) are known.

However, these compositions have disadvantages. In removing a resist-film produced from such a composition using an aqueous alkaline solution, the resist-film is swollen and exfoliated without being dissolved. The film then causes blockage of the filter or the spouting nozzle for the aqueous alkaline solution.

The present inventors have now found a photopolymerizable composition suitable for preparing an etching-resist ink which is curable by irradiation of ultraviolet rays. The cured etching-resist ink is soluble in an aqueous alkaline solution.

The present invention provides a photopolymerizable composition comprising poly-N-vinylpyrrolidone (A), a compound (B) represented by the formula (I):

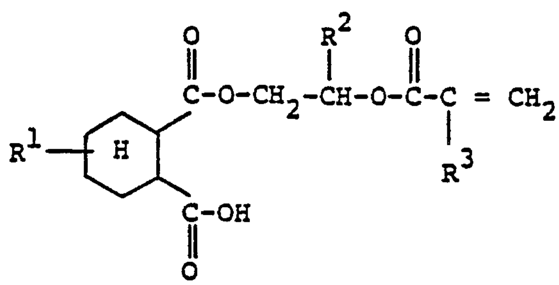

(I)

wherein each of $R^1$, $R^2$ and $R^3$ represents independently a hydrogen atom or a methyl group; an acid amide (C) represented by the formula (II):

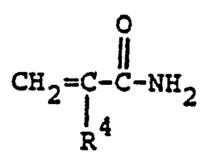

(II)

wherein $R^1$ represents a hydrogen atom or a methyl group, and one or more monomeric compound (D) containing an acryloyl group or a methacryloyl group. The composition optionally further comprises a photopolymerization-initiator (E).

The photopolymerizable composition according to the present invention is curable by irradiation with ultraviolet rays to obtain a cured material having excellent hardness and acid-resistance. The thus cured material is soluble in an aqueous alkaline solution.

The photopolymerizable composition according to the present invention is not only utilizable as an etching-resist ink for producing a printed-circuit board but it also utilizable in any field where, after having accomplished a function as a cured film, the cured film is to be removed by utilizing the specific property that the cured film is acid-resistant and is soluble in an aqueous alkaline solution. The photopolymerizable composition according to the present invention may also be used as a plating resist. Furthermore, it may be used in the general coating field.

Poly-N-vinylpyrrolidone (A), used as a binder polymer, preferably has a molecular weight of from 10,000 to 1,000,000, more preferably of from 20,000 to 900,000. For instance, those sold under the registered trade marks Luviskol K-30 and K-90 by BASF Co. may be mentioned.

The compound (B) is available as the product of an equimolecular reaction between hexahydrophthalic anhydride or methylhexahydrophthalic anhydride and 2-hydroxyalkyl acrylate or 2-hydroxyalkyl methacrylate. As the 2-hydroxyalkyl acrylate or 2-hydroxyalkyl methacrylate, 2-hydroxyethyl acrylate, 2-hydroxyethyl methacrylate and 2-hydroxypropyl methacrylate may be exemplified. Examples of synthesis of the compound (B) are shown in the following Synthetic Examples.

Synthetic Example 1:

Synthesis of the compound (B) No. 1

In a 1.0-litre flask provided with a stirring device, a thermometer and a condenser, 154.18 parts by weight of hexahydrophthalic anhydride, 121.8 parts by weight of 2-hydroxyethyl acrylate and 0.138 part by weight of hydroquinone monomethyl ether as a polymerization-inhibitor were introduced at the same time.

The mixture was slowly heated and gently stirred until the solid hexahydrophthalic anhydride dissolved. After complete dissolution of the hexahydrophthalic anhydride, the reaction was continued for 19 hours while maintaining the temperature of the mixture at 90 ± 5°C. The half ester of formula (I) wherein $R^1$, $R^2$ and $R^3$ are hydrogen atoms, having the following properties, was obtained.

| | |
|---|---|
| Acid value (mgKOH/g): | 201.0 |
| Viscosity (Pas, at 25°C): | 3.35 (3350.0 cps) |
| Specific gravity (at 25°C): | 1.197 |

Synthetic Example 2:

Synthesis of the compound (B) No. 2

In a 1-litre flask provided with the same devices as in Synthetic Example 1, 154.18 parts by weight of hexahydrophthalic anhydride, 136.7 parts by weight of 2-hydroxyethyl methacrylate and 0.145 part by weight of hydroquinone monomethyl ether as a polymerization-inhibitor were introduced at the same time. The mixture was reacted as in Synthetic Example 1 to form a half ester of formula (I) wherein $R^1$ and $R^2$ are hydrogen atoms and $R^3$ is a methyl group, having the following properties.

| | |
|---|---|
| Acid value (mgKOH/g): | 193.0 |
| Viscosity (Pas, at 35°C): | 0.95 (950 cps) |
| Specific gravity (at 35°C): | 1.165 |

Synthetic Example 3:

Synthesis of the compound (B) No. 3

In a 1-litre flask provided with the same devices as Synthetic Example 1, 168 parts by weight of 4-methylhexahydrophthalic anhydride, 121.8 parts by weight of 2-hydroxyethyl acrylate and 0.137 part by weight of hydroquinone monomethyl ether as a polymerization-inhibitor were introduced at the same time. The mixture was reacted as in Synthetic Example 1 to form the half ester of formula (I) wherein $R^1$ is a 4-methyl group and $R^2$ and $R^3$ are hydrogen atoms, having the following properties.

| | |
|---|---|
| Acid value (mgKOH/g): | 202.0 |
| Viscosity (Pas, at 25°C): | 4.8 (4800 cps) |
| Specific gravity (at 25°C): | 1.1700 |

Examples of the acid amide (C) are acrylamide and methacrylamide.

As the monomer (D), various esters of acrylic acid and methacrylic acid may, for example, be mentioned, for instance, carbitol acrylate, carbitol methacrylate, tetrahydrofurfuryl acrylate, tetrahydrofurfuryl methacrylate, 2-hydroxyethyl acrylate, 2-hydroxyethyl methacrylate, 2-hydroxypropyl acrylate, 2-hydroxypropyl methacrylate, methyl acrylate, methyl methacrylate, ethyl acrylate, ethyl methacrylate, propyl acrylate, propyl methacrylate, butyl acrylate, butyl methacrylate, 2-ethylhexyl acrylate, 2-ethylhexyl methacrylate, phenoxyethyl acrylate and phenoxyethyl methacrylate. Each of the above-mentioned monomers may be used singly or in combination thereof as a mixture. Particularly preferred monomers (D) are carbitol acrylate, carbitol methacrylate, 2-hydroxypropyl methacrylate, 2-hydroxyethyl acrylate, 2-hydroxyethyl methacrylate and phenoxyethyl methacrylate.

As the photopolymerization-initiator (E), any one of the known photopolymerization-initiators such as diacetyl, benzoin, acyloins, ethers, aromatic ketones and aromatic aldehydes may be mentioned.

Suitable photopolymerization-initiators (E), are benzoin alkyl ethers such as benzoin ethyl ether, benzoin isobutyl ether and benzoin isopropyl ether, acetophenones such as 2,2-diethyoxyacetophenone and 4′-phenoxy-2,2-dichloroacetophenone, propiophenones such as 2-hydroxy-2-methylpropiophenone, 4′-dodecyl-2-hydroxy-2-methylpropiophenone and 4′-dodecyl-2-hydroxy-2-methylpropiophenone, anthraquinones such as 2-ethylanthraquinone and 2-chloroanthraquinone, benzyl dimethyl ketal, 1-hydroxycyclohexyl phenyl ketone and thioxantones. Each of the above-mentioned photopolymerization-initiators may be used singly or in combination as a mixture.

In order to produce the photopolymerisable composition according to the present invention, in case of necessity, a polymerization-inhibitor, for instance, methoquinone or methylhydroquinone; a viscosity-raising agent, for instance, silica; a levelling agent, for instance MODAFLOW® or FLORATE®; a fluidity-improving agent; a frosting agent; plasticizers; fillers such as barium sulfate or calcium sulfate; colouring agent(s) such as pigment(s) and dyestuff(s) and other additives may be added.

The components (A) to (E) are preferably present in the composition according to the present invention in amounts of from 0.5 to 20% by weight, from 55 to 85% by weight, from 5 to 20% by weight, from 5 to 20% by weight and from 0 to 10% by weight, respectively, based on the total amount of components (A), (B), (C), (D) and (E). The photopolymerizable composition containing these amounts of each of the components is especially good for making inks, and the cured film made therefrom may be dissolved quite easily in aqueous alkaline solution. In the case where component (E) is used, the amount thereof is preferably from 1 to 10% by weight of the total amount of components (A) to (E) of the composition. The particularly preferred amount of each of the components (A) to (E) is from 2 to 7% by weight, from 70 to 80% by weight, from 5 to 15% by weight, from 5 to 15% by weight and from 1 to 7% by weight, respectively.

The photopolymerizable composition according to the present invention may be produced by uniformly mixing the components.

In the case where the composition according to the present invention is used as the etching-resist ink, it may be used in the following manner:

A copper-clad laminate is printed with a composition according to the present invention by using a screen, and then the printed composition is irradiated with ultraviolet rays (for instance a 2-kw high pressure mercury lamp) to cure the thus printed composition. The thus treated laminate having a cured film is soaked in an etching liquid (for instance an aqueous solution of hydrochloric acid containing cupric chloride) to remove the copper not covered by the cured film. On washing the thus treated laminate having the cured film with an aqueous alkaline solution (for instance an aqueous solution of sodium hydroxide) the cured film dissolves in the aqueous alkaline solution and is removed from the laminate. The pH of the aqueous solution is preferably from 11 to 13.

The present invention is further described in the following Examples and Comparative Example.

Example 1:

After preparing a photopolymerizable composition comprising 4.0 parts by weight of a poly-N-vinylpyrrolidone (having a molecular weight of 40,000, made by BASF Company under the trade name of Luviskol K-30) (component (A), a polymer for use as a binder), 24.8 parts by weight of the compound (B) synthesized in Synthetic Exampele 1, 24.0 parts by weight of the compound (B) synthesized in Synthetic Example 2, 6.6 parts by weight of methacrylamide (C) and 7.0 parts by weight of carbitol acrylate (D) according to the present invention, the composition was uniformly mixed with 3.8 parts by weight of benzyl dimethyl ketal (E), 0.5 parts by weight of cyanin blue, 0.9 parts by weight of MODAFLOW® (a levelling agent, made by Monsanto Co.) and 28.4 parts by weight of talc as a filler. After sufficiently kneading the mixture by a kneading machine provided with three rollers (made by INOUE Works Co. Ltd), the thus prepared material was printed onto a copper foil on the base plate of a printed-circuit board according to the screen-printing method while using a screen with a pattern having five bands of 0.1 mm, 0.15 mm, 0.2 mm, 0.3 mm, 0.8 mm and 1.0 mm in width. By irradiating the thus printed plate with ultraviolet rays from a 2-kw mercury lamp, a specimen having coating film of 4H in hardness (of a pencil) was obtained. On treating the thus obtained specimen with an etching liquid (an aqueous solution of hydrochloric acid containing cupric chloride) at 50°C for 30 min, no abnormal finding was observed on the state of the coating film with widths in the range of from 0.1 to 1.0 mm.

On treating the cured film with an aqueous 5% solution of sodium hydroxide, the cured film dissolved within 18 s.

Example 2:

After uniformly mixing a composition according to the present invention comprising 2.96 parts by weight of poly-N-vinylpyrrolidone (having a molecular weight of 4000, made by BASF Company under the trade name of Luviskol K-30) (component (A), as the polymer for binder), 10.58 parts by weight of the compound (B) synethesized in Synthetic Example 2, 39.53 parts by weight of the compound (B) synthesized in Synthetic Example 3, 6.92 parts by weight of methacrylamide (C), 4.94 parts by weight of 2-hydroxypropyl methacrylate (D), 3.95 parts by weight of benzyl dimethyl ketal (E), 0.5 parts by weight of an organic pigment (cyanin blue), 0.99 parts by weight of MODAFLOW® and 29.64 parts weight of talc, the thus mixed composition was printed onto a copper foil on the base plate of a printed-circuit board in the same manner as in Example 1. The thus printed plate was treated in the same manner as in Example 1 to obtain a specimen having the cured film of 3H in pencil-hardness.

On treating the thus obtained specimen with an etching liquid (an aqueous solution of hydrochloric acid containing cupric chloride) at 50°C for 30 min, the state of the coating film of 0.1 to 1.0 mm in width was maintained without any abnormal findings. On treating the thus cured film with an aqueous 5% solution of sodium hydroxide, the film dissolved within 21 s.

Example 3:

A composition comprising the same components and the same amount of the components as in Example 2 except for using acrylamide (C) instead of methacrylamide was uniformly mixed and, after subjecting the thus prepared composition to kneading, printing and curing in the same procedures as in Example 1, a specimen having a cured film of 3H in pencil-hardness was obtained. On treating the thus obtained specimen with an etching liquid (an aqueous solution of hydrochloric acid containing cupric chloride) at 50°C for 30 min, the state of the thus cured film of 0.1 to 1.0 mm in width did not show any abnormal findings. On treating the thus cured film with an aqueous 5% solution of sodium hydroxide, the film dissolved within 26 s.

Example 4:

After uniformly mixing a composition according to the present invention comprising 1.26 parts by weight of poly-N-vnylpyrrolidone (A) (having a molecular weight of 700,000, made by BASF Company under the trade name of Luviskol K-90), 25.28 parts by weight of the compound (B) synthesized in Synthetic Example 1, 24.69 parts by weight of the compound (B) synethesized in Synthetic Example 2, 6.77 parts by weight of methacrylamide (C), 7.26 parts by weight of carbitol acrylate (D), 3.87 parts by weight of benzyl dimethyl ketal (E), 0.5 parts by weight of cyanin blue, 0.97 parts by weight of MODAFLOW® and 29.04 parts by weight of talc, the thus mixed composition was subjected to kneading, printing and curing as in Example 1 to obtain a specimen having a cured film of 4H in pencil-hardness. On treating the thus obtained specimen with an etching liquid (an aqueous solution of hydrochloric acid containing cupric chloride) at 50°C for 30 min, no abnormal finding was observed on the state of the cured film of 0.1 to 1.0 mm in width.

On treating the cured film with an aqueous 5% solution of sodium hydroxide at 50°C, the film dissolved within 20 s.

Example 5:

In the same manner as in Example 1 except for using phenoxyethyl methacrylate instead of carbitol acrylate (D), a specimen was obtained. The thus obtained specimen showed the same results as that of Example 1.

Comparative Example 1:

Into a 1-litre three-necked flask provided with a stirrer, a thermometer and a separating funnel having a condenser, 80 g (1.05 mol) of propylene glycol, 25 g (0.15 mol) of isophthalic acid and 99 g (0.85 mol) of maleic anhydride were introduced. By reacting the thus introduced material at a temperature of from 50 to 200°C for 18 hours in a gaseous nitrogen atmosphere a polyester was obtained. After uniformly mixing a composition comprising 4.4 parts by weight of the thus obtained polyester having a softening point of 60.5°C and acid value of 53, 25.61 parts by weight of the compound (B) synthesized in Synthetic Example 1, 24.88 parts by weight of the compound (B) synthesized in Synthetic Example 2, 7.32 parts by weight of carbitol acrylate, 2.93 parts by weight of 2-hydroxypropyl methacrylate, 3.90 parts by weight of benzyl dimethyl ketal, 0.5 parts by weight of cyanin blue, 0.99 parts by weight of MODAFLOW® and 29.27 parts by weight of talc, the thus mixed composition was subjected to kneading, printing and curing as in Example 1 to obtain a specimen having a cured film of 3H in pencil-hardness. On treating the specimen in the same procedures as in Example 1, although the films treated with the etching liquid (an aqueous solution of hydrocholoric acid containing cupric chloride) showed no abnormal state (films of the width of from 0.1 to 1.0 mm), the cured film was swollen on treatment with an aqueous 5% solution of sodium hydroxide and then exfoliated from the specimen within 30 s. The cured film did not dissolve in the aqueous alkaline solution.

**Claims**

1. A photopolymerizable composition comprising poly-N-vinylpyrrolidone (A), a compound (B) represented by the formula (I):

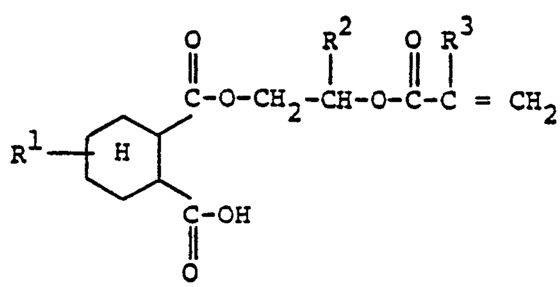

(I)

wherein each of $R^1$, $R^2$ and $R^3$ represents independently a hydrogen atom or a methyl group, an acid amide (C) represented by the formula (II):

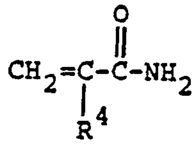

(II)

wherein $R^4$ represents a hydrogen atom or a methyl group, and one or more monomeric compound (D) containing an acryloyl group of a methacryloyl group.

2. A composition according to claim 1, further comprising a polymerization-initiator (E).

3. A composition according to claim 1 or 2, comprising components (A), (B), (C), (D) and (E) in amounts of from 0.5 to 20% by weight, from 55 to 85% by weight, from 5 to 20% by weight, from 5 to 20% by weight and from 0 to 10% by weight, respectively, based on the total amount of components (A), (B), (C), (D), and (E).

4. A composition according to claim 3, wherein the amount of component (E) is from 1 to 10% by weight.

5. A composition according to any one of the preceding claims, wherein the molecular weight of the poly-N-vinyl-pyrrolidone (A) is from 10,000 to 1,000,000.

6. A composition according to any one of the preceding claims, wherein compound (B) is a compound of formula (I) wherein each of $R^1$, $R^2$ and $R^3$ is hydrogen and which has an acid value (mgKOH/g) of 201.0, a viscosity (Pas, at 25°C) of 3.35 and a specific gravity (at 25°C) of 1.197.

7. A composition according to any one of claims 1 to 5, wherein compound (B) is a compound of

formula (I) wherein $R^1$ and $R^2$ are both hydrogen and $R^3$ is methyl and which has an acid value (mgKOH/g) of 193.0, a viscosity (Pas, at 35°C) of 0.95 and a specific gravity (at 25°C) of 1.165.

8. A composition according to any one of claims 1 to 5, wherein compound (B) is a compound of formula (I) wherein $R^1$ is a 4-methyl group and $R^2$ and $R^3$ are both hydrogen and which has an acid value (mgKOH/g) of 202.0, a viscosity (Pas, at 25°C) of 4.8 and a specific gravity (at 25°C) of 1.1700.

9. A composition according to any one of the preceding claims, wherein the or each monomer (D) is selected from carbitol acrylate, carbitol methacrylate, tetrahydrofurfuryl acrylate, tetrahydrofurfuryl methacrylate, 2-hydroxyethyl acrylate, 2-hydroxyethyl methacrylate, 2-hydroxypropyl acrylate, 2-hydroxypropyl methacrylate, methyl acrylate, methyl methacrylate, ethyl acrylate, ethyl methacrylate, propyl acrylate, propyl methacrylate, butyl acrylate, butyl methacrylate, 2-ethylhexyl acrylate, 2-ethylhexyl methacrylate, phenoxyethyl acrylate and phenoxyethyl methacrylate.

10. use of a photopolymerizable composition according to any one of the preceding claims as an etching-resist ink.

**Patentansprüche**

1. Photopolymerisierbare Zusammensetzung, die Poly-N-vinylpyrrolidon (A), eine durch die Formel (I):

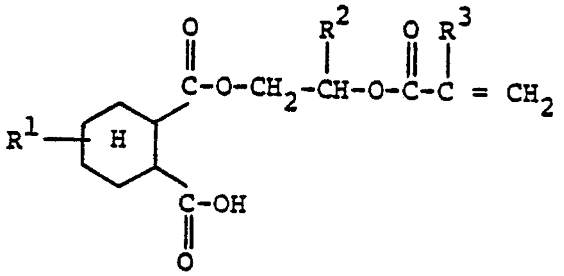

(I)

dargestellte Verbindung (B), in der unabhängig voneinander jeder Rest $R^1$, $R^2$ und $R^3$ ein Wasserstoffatom oder eine Methylgruppe darstellt, ein durch die Formel (II):

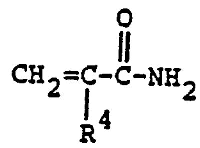

(II)

dargestelltes Säureamid (C), in der $R^4$ ein Wasserstoffatom oder eine Methylgruppe darstellt, und eine oder mehrere monomere Verbindungen (D) enthält, die eine Acryloyl-Gruppe oder eine Methacryloyl-Gruppe enthalten.

2. Zusammensetzung nach Anspruch 1, die außerdem einen Polymerisationsinitiator (E) enthält.

3. Zusammensetzung nach Anspruch 1 oder 2, die die Komponenten (A), (B), (C), (D) und (E) in Mengen von 0,5 bis 20 Gew.%, 55 bis 85 Gew.%, 5 bis 20 Gew.% bzw. 0 bis 10 Gew.% bezogen auf die Gesamtmenge der Komponenten (A), (B), (C), (D) and (E) enthält.

4. Zusammensetzung nach Anspruch 3, in der die Menge der Komponente (E) 1 bis 10 Gew.% beträgt.

5. Zusammensetzung nach einem der vorangehenden Ansprüche, in der das Molekulargewicht des Poly-N-vinylpyrrolidons (A) 10.000 bis 1.000.000 beträgt.

6. Zusammensetzung nach einem der vorangehenden Ansprüche, in der Verbindung (B) eine Verbindung der Formel (I) ist, in der jeder von $R^1$, $R^2$ and $R^3$ Wasserstoff ist und die einen Säurewert (mg KOH/g) von 201,0, eine Viskosität (Pas, bei 25°C) von 3,35 und ein spezifisches Gewicht (bei 25°C) von 1,197 aufweist.

7. Zusammensetzung nach einem der Ansprüche 1 bis 5, in der Verbindung (B) eine Verbindung der Formel (I) ist, in der $R^1$ und $R^2$ beide Wasserstoff sind und $R^3$ Methyl ist und die einen Säurewert (mg KOH/g) von 193,0, eine Viskosität (Pas, bein 35°C) von 0,95 und ein spezifisches Gewicht (bei 25°C) von 1,165 aufweist.

8. Zusammensetzung nach einem der Ansprüche 1 bis 5, in der Verbindung (B) eine Verbindung der Formel (I) ist, in der $R^1$ eine 4-Methylgruppe ist und $R^2$ and $R^3$ beide Wasserstoff sind und die einen Säurewert (mg KOH/g) von 202,0, eine Viskosität (Pas, bei 25°C) von 4,8 und ein spezifisches Gewicht (bei 25°C) von 1,1700 aufweist.

9. Zusammensetzung nach einem der vorangehenden Ansprüche, in der das oder jedes Monomere (D) aus Carbitolacrylat, Carbitolmethacrylat, Tetrahydrofurfurylacrylat, Tetrahydrofurfurylmethacrylat, 2-Hydroxyethylacrylat, 2-Hydroxyethylmethacrylat, 2-Hydroxypropylacrylat, 2-Hydroxypropylmethacrylat, Methylacrylat, Methylmethacrylat, Ethylacrylat, Ethylmethacrylat, Propylacrylat, Propylmethacrylat, Butylacrylat, Butylmethacrylat, 2-Ethylhexylacrylat, 2-Ethylhexylmethacrylat, Phenoxyethylacrylat und Phenoxyethylmethacrylat ausgewählt ist.

10. Verwendung einer photopolymerisierbaren Zusammensetzung nach einem der vorangehenden Ansprüche als eine dem Atzen widerstehende Tinte.

**Revendications**

1. Composition photopolymérisable comprenant de la poly-N-vinylpyrrolidone (A), un composé (B) représenté par la formule (I):

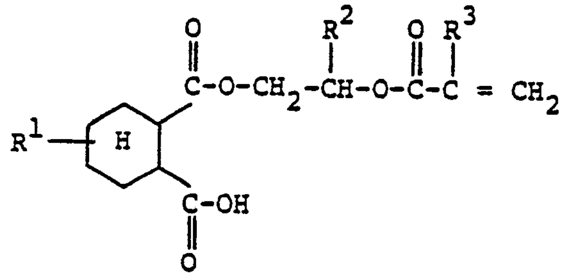

(I)

dans laquelle chacun des $R^1$, $R^2$ et $R^3$ représente de façon indépendante un atome d'hydrogène ou un radical méthyle, un amide acide (C) représenté par la formule (II):

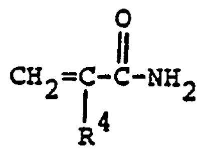

(II)

dans laquelle $R^4$ représente un atome d'hydrogène ou un radical méthyle, et un ou plusieurs composés monomères (D) contenant un radical acroyle ou un radical méthacroyle.

2. Composition suivant la revendication 1, comprenant un initiateur de polymérisation (E).

3. Composition suivant la revendication 1 ou 2, comprenant les composants (A), (B), (C), (D) et (E) dans des proportions respectivement de 0,5 à 20% en poids, de 55 à 85% en poids, de 4 à 20% en poids, de 5 à 20% en poids et de 0 à 10% en poids, ramenées à la quantité totale de ces composants (A), (B), (C), (D) et (E).

4. Composition suivant la revendication 3, dans laquelle la proportion du composé (E) est de 1 à 10% en poids.

5. Composition suivant l'une quelconque des revendications précédentes, dans laquelle le poids moléculaire de la poly-N-vinylpyrrolidone (A) est de 10.000 à 1.000.000.

6. Composition suivant l'une quelconque des revendications précédentes, dans laquelle le composé (B) est un composé de formule (I) dans lequel chacun des $R^1$, $R^2$ et $R^3$ est l'hydrogène et qui a un indice d'acide (mg KOH/g) de 201,0, une viscosité (Pa, à 25°C) de 3,35 et une densité (à 25°C) de 1,197.

7. Composition suivant l'une quelconque des revendications 1 à 5, dans laquelle le composé (B) est un composé de formule (I) dans laquelle $R^1$ et $R^2$ sont tous deux l'hydrogène et $R^3$ est un méthyle et qui a un indice d'acide (mg KOH/g) de 193,0, une viscosité (Pa, à 25°C) de 0,95 et une densité (à 25°C) de 1,165.

8. Composition suivant l'une quelconque des revendications 1 à 5, dans laquelle le composé (B) est un composé de formule (I) dans laquelle $R^1$ est un radical méthyle-4 et $R^2$ et $R^3$ sont tous deux l'hydrogène et qui a un indice d'acide (mg KOH/g) de 202,0, une viscosité (Pa, à 25°C) de 4,8 et une densité (à 25°C) de 1,1700.

9. Composition suivant l'une quelconque des revendications précédentes, dans laquelle le ou chaque monomère (D) est choisi parmi l'acrylate de carbitol, le méthacrylate de carbitol, l'acrylate de tétrahydrofurfuryle, le méthacrylate de tétrahydrofurfuryle, l'acrylate d'hydroxy-2 éthyle, le méthacrylate d'hydroxy-2 éthyle, l'acrylate d'hydroxy-2 propyle, le méthacrylate d'hydroxy-2 propyle, l'acrylate de méthyle, le méthacrylate de méthyle, l'acrylate d'éthyle, le méthacrylate d'éthyle, l'acrylate de propyle, le méthacrylate de propyle, l'acrylate de butyle, le méthacrylate de butyle, l'acrylate d'éthyle-2 hexyle, le méthacrylate d'éthyle-2 hexyle, l'acrylate de phénoxyéthyle et le méthacrylate de phénoxyéthyle.

10. Utilisation d'une composition photopolymérisable suivant l'une quelconque des revendications précédentes en tant que vernis résistant à la gravure.